Europäisches Patentamt

European Patent Office

Office européen des brevets

(19)

(11) Numéro de publication: **0 342 579**
A1

## (12) DEMANDE DE BREVET EUROPEEN

(21) Numéro de dépôt: 89108732.2

(22) Date de dépôt: 16.05.89

(51) Int. Cl.⁴: **H02J 9/00 , G01R 31/36**

(30) Priorité: 20.05.88 FR 8806795

(43) Date de publication de la demande:
23.11.89 Bulletin 89/47

(84) Etats contractants désignés:
AT BE CH DE ES FR GB IT LI LU NL SE

(71) Demandeur: Société Anonyme dite SAFT
156, avenue de Metz
F-93230 Romainville(FR)

(72) Inventeur: Mangez, Jean-Claude
2 boulevard Gambetta
F - 93130 Noisy-Le-Sec(FR)

(74) Mandataire: Weinmiller, Jürgen et al
Lennéstrasse 9 Postfach 24
D-8133 Feldafing(DE)

(54) Appareil de test d'autonomie pour bloc d'éclairage de sécurité.

(57) Cet appareil de test d'autonomie (3) comporte : un compteur de temps (30) qui est déclenchable par un circuit de réception d'ordre de test d'autonomie (38) connecté à une entrée de télécommande (18) du bloc d'éclairage de sécurité (1), un circuit de simulation (36) qui est contrôlé par le compteur de temps (30) et qui, pendant le fonctionnement de ce dernier, simule une coupure de l'alimentation normale (2) pour un circuit de gestion de bloc (15) pilotant un interrupteur commandé (14) contrôlant dans le bloc (1) le branchement des lampes de sécurité (130, 131) aux bornes d'une batterie d'accumulateurs (11), un circuit de visualisation (35) de la durée de fonctionnement du compteur de temps (30) et un circuit (45) de mesure du courant traversant chaque lampes de sécurité (130, 131) qui bloque le compteur de temps (30) dès l'extinction de l'une desdites lampes de sécurité.

FIG.1

Xerox Copy Centre

## Appareil de test d'autonomie pour bloc d'éclairage de sécurité

La présente invention concerne les dispositifs de test d'autonomie des blocs d'éclairage de sécurité maintenant un éclairage minimum dans des locaux en cas de défaillance de l'éclairage normal dues à une coupure du réseau d'alimentation normale en énergie électrique.

Les blocs d'éclairage de sécurité comportent en général une batterie d'accumulateurs NiCd pourvue d'un dispositif de charge et une lampe d'éclairage de sécurité en général doublée, connectée aux bornes de la batterie d'accumulateurs au moyen d'un interrupteur commandé par un circuit de gestion de bloc qui le ferme lorsque l'alimentation normale disparaît et que la batterie d'accumulateurs délivre une tension supérieure à un seuil minimum.

On doit effectuer régulièrement différents tests sur ces blocs d'éclairage de sécurité pour vérifier qu'ils sont à tout moment en état d'assurer leur fonction d'éclairage de sécurité, notamment des tests d'autonomie. On connaît pour ce faire, par le brevet français n° 2 568 065 un dispositif de test d'autonomie comportant un compteur de temps déclenchable qui est bloqué en cas d'ouverture de l'interrupteur commandé, un circuit de simulation qui est contrôlé par le compteur de temps et qui, pendant le fonctionnement de ce dernier simule, pour le circuit de gestion de bloc, une coupure de l'alimentation normale, et un circuit de visualisation de la durée de fonctionnement du compteur de temps.

Ce dispositif de test permet de vérifier facilement l'autonomie d'un bloc d'éclairage de sécurité sans couper son alimentation, mais il présente cependant l'inconvénient de ne pas vérifier le fonctionnement de la ou des lampes de sécurité. De ce fait, le résultat du test d'autonomie n'est valable, que si l'ensemble des lampes de sécurité sont en état de fonctionner.

Dans le cas contraire, le courant délivré par la batterie d'accumulateurs étant inférieur à la normale, le test d'autonomie peut être déclaré bon alors qu'en fait la batterie d'accumulateurs n'est plus en état d'assurer l'autonomie en alimentant la totalité des lampes.

Pour vérifier le bon état des lampes de sécurité, il est possible d'utiliser des éléments photosensibles. Cette solution est employée pour des blocs d'éclairage de sécurité comportant une seule lampe à fluorescence. Cependant, elle ne convient pas pour des blocs d'éclairage de sécurité à plusieurs lampes à incandescence car on se heurte à la difficulté d'implanter à proximité de chaque lampe à incandescence un élément photosensible de telle sorte qu'il ne soit perturbé, ni par le rayonnement thermique de la lampe auprès de laquelle il est placé, ni par la lumière émise par les autres lampes. Il est en outre difficile, du fait de la dispersion des éléments photosensibles, de détecter la présence d'une lampe dont la puissance nominale est inférieure à la normale.

La présente invention a pour but un appareil de test simple et peu coûteux qui remédie à ces difficultés et inconvénients.

Elle a pour objet un appareil de test d'autonomie pour bloc d'éclairage de sécurité pourvu d'au moins une lampe d'éclairage de sécurité, d'une batterie d'accumulateurs destinée à alimenter la lampe d'éclairage de sécurité, d'un circuit de charge de la batterie d'accumulateurs connecté à une alimentation dite normale dont la coupure doit entraîner l'allumage du bloc d'éclairage de sécurité, d'un interrupteur commandé connectant la lampe d'éclairage aux bornes de la batterie d'accumulateurs et d'un dispositif de gestion de bloc commandant l'interrupteur commandé et le fermant lorsque l'alimentation normale disparaît et que la batterie d'accumulateurs délivre une tension supérieure à un seuil minimum. Cet appareil de test comporte un compteur de temps déclenchable, un circuit de simulation qui est contrôlé par le compteur de temps et qui, pendant le fonctionnement de ce dernier simule, pour le circuit de gestion de bloc, une coupure de l'alimentation normale, un circuit de visualisation de la durée de fonctionnement du compteur de temps et un circuit de mesure du courant traversant chaque lampe de sécurité bloquant ledit compteur de temps lorsque ledit courant est inférieur à une valeur de seuil.

Selon un mode préféré de réalisation, une résistance shunt est intercalée en série avec chaque lampe d'éclairage de sécurité et le circuit de mesure de courant comporte une source de tension de référence formée de la jonction émetteur base d'un transistor dont la base est reliée au collecteur, dont l'émetteur est connecté avec une extrémité des résistances shunt à un pôle de la batterie d'accumulateurs et dont le collecteur est relié par l'intermédiaire d'une résistance de polarisation à l'autre pôle de la batterie d'accumulateurs et des transistors en nombre égal à celui des lampes d'éclairage de sécurité montés en détecteur à seuil avec leurs émetteurs connectés aux points d'interconnexion des lampes d'éclairage de sécurité et de leurs résistances shunt, leurs bases connectées à la base du transistor de la source de tension de référence et leurs collecteurs connectés ensemble en sortie du circuit de mesure de courant.

D'autres caractéristiques et avantages de l'invention ressortiront de la description ci-après d'un mode de réalisation de l'invention donné à titre d'exemple. Cette description sera faite en regard du dessin dans lequel :

- la figure 1 représente, de manière schématique, un bloc d'éclairage de sécurité télécommandable pourvu d'un dispositif de test selon l'invention,

- la figure 2 détaille le circuit électrique du bloc d'éclairage de sécurité de la figure 1 avec ses points d'interconnexion au dispositif de test et

- la figure 3 détaille le schéma électrique du dispositif de test de la figure 1 et ses points d'interconnexion avec le circuit électrique du bloc d'éclairage de sécurité représenté à la figure 2.

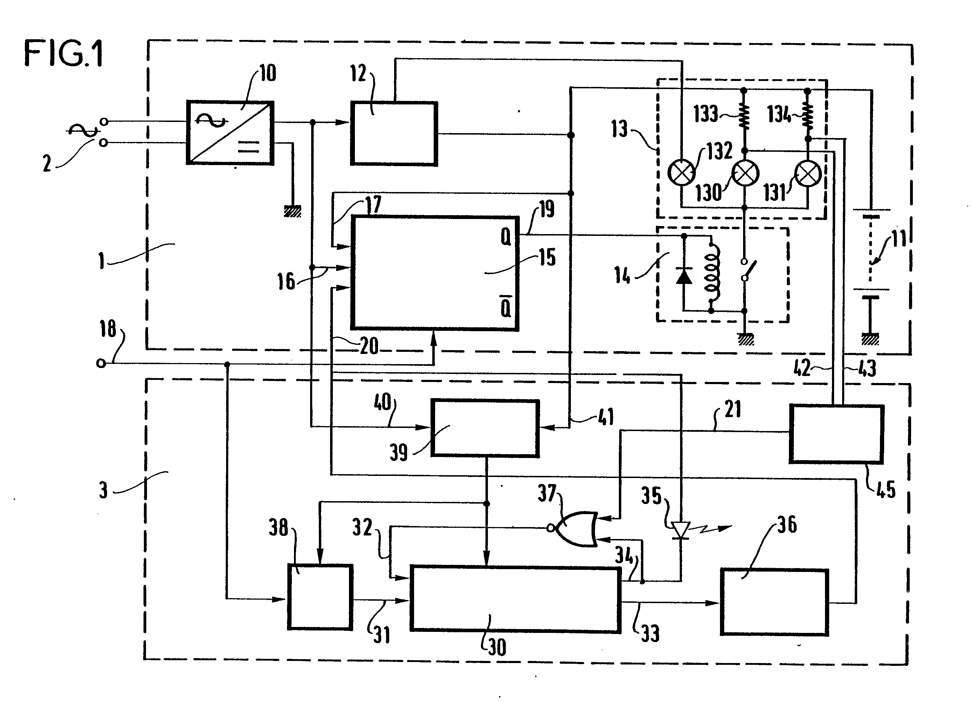

On distingue sur la figure 1, un bloc d'éclairage de sécurité 1 alimenté par le secteur 2 qui constitue la source d'alimentation normale et équipé d'un dispositif de test d'autonomie 3.

Le bloc d'éclairage de sécurité 1 comporte :
- un circuit d'alimentation 10 redressant la tension alternative du secteur 2 et la transformant en une tension continue de valeur adéquate,
- une batterie d'accumulateurs 11 avec son circuit de charge 12 alimenté par la tension continue délivrée par le circuit d'alimenta tion 10,
- un ensemble de lampes 13 dont deux d'éclairage de sécurité 130, 131 sont branchées aux bornes de la batterie d'accumulateurs 11 par l'intermédiaire d'un interrupteur commandé 14 et de résistances shunt 133, 134, et dont une troisième de test 132 placée en série avec les lampes d'éclairage de sécurité 130, 131 en dérivation partielle sur le circuit de charge 12 atteste lorsqu'elle est allumée du bon état de l'une au moins des lampes d'éclairage de sécurité 130, 131 et de la charge effective de la batterie d'accumulateurs 11,
- et un circuit de gestion de bloc 15 contrôlant l'interrupteur commandé 14 de manière à le fermer et allumer les lampes d'éclairage de sécurité lorsque la tension du circuit d'alimentation 10 disparaît et que la tension délivrée par la batterie d'accumulateurs 11 est supérieure à une valeur minimum.

Les résistances shunt 133, 134 sont de faible valeur et avantageusement constituées par des pistes de la plaquette de circuit imprimé supportant les différents composants du bloc d'éclairage de sécurité.

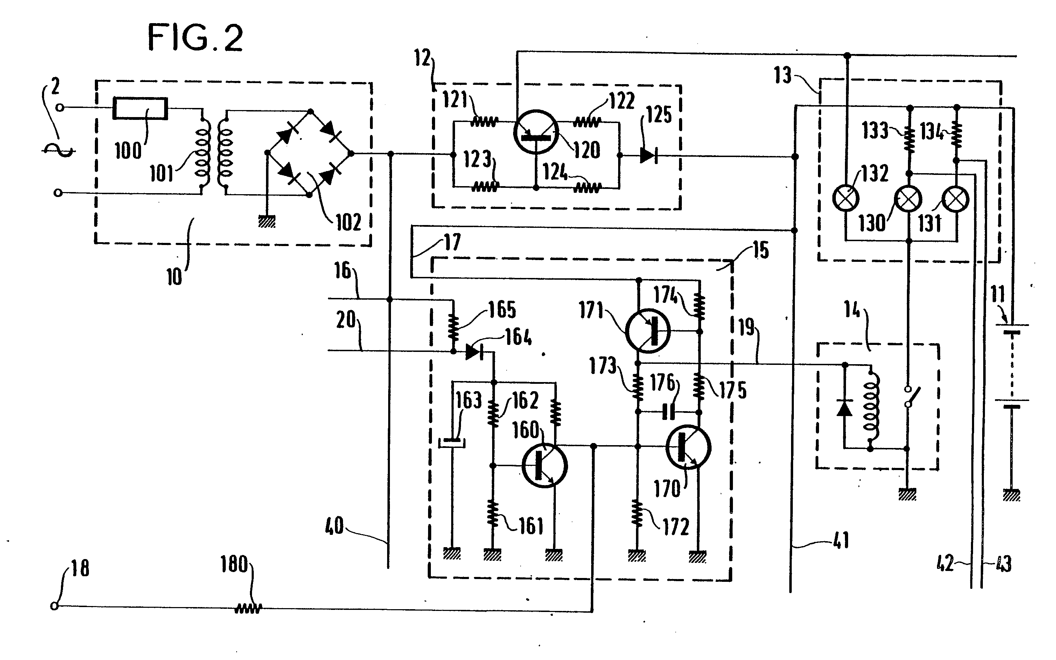

Le circuit de gestion de bloc 15 qui sera décrit dans le détail en regard de la figure 2 comporte une entrée 16 de surveillance de la tension de la source d'alimentation normale connectée en sortie du circuit d'alimentation 10, une entrée 17 de surveillance de la tension de la batterie d'accumulateurs, une entrée de télécommande 18 permettant à volonté, d'éteindre et de réallumer le bloc d'éclairage de sécurité pendant une coupure de l'alimentation normale et une sortie 19 de commande du relais constituant l'interrupteur commandé 14.

Il est en outre pourvu, pour les besoins du dispositif de test 3, d'une entrée d'inhibition 20 permettant de forcer à zéro son entrée 16 de surveillance de la tension d'alimentation normale.

Le dispositif de test 3 comporte :
- un compteur de temps 30 avec une entrée de déclenchement 31, une entrée de blocage 32, une sortie d'état 33 qui délivre un signal binaire représentatif de l'état de marche ou d'arrêt du compteur de temps et une sortie de visualisation 34 excitant un voyant 35 au bout d'une certaine durée de fonctionnement du compteur coïncidant avec la durée du test d'autonomie,
- un circuit de simulation 36 qui est commandé par la sortie d'état 33 du compteur de temps et agit sur l'entrée d'inhibition 20 du circuit de gestion de bloc 15 de manière à simuler pour ce dernier une coupure de la tension de l'alimentation normale lorsque le compteur de temps 30 fonctionne,
- un circuit 45 de mesure du courant traversant les lampes d'éclairage de sécurité 130, 131 qui est relié par deux entrées 42, 43 aux points de connexion des lampes d'éclairage de sécurité 130, 131 avec leur résistance shunt 133, 134 et qui délivre sur sa sortie 21 un signal binaire représentatif de l'état d'extinction de l'une des lampes d'éclairage de sécurité 130, 131 ou de l'état d'allumage dès deux,
- une porte logique 37 de type "non ou" à deux entrées connectée en sortie à l'entrée de blocage du compteur de temps 30 et, en entrée, à la sortie de visualisation 34 du compteur de temps ce qui transforme ce dernier en minuterie et, à la sortie 21 du circuit de mesure de courant 45 ce qui permet de bloquer le compteur de temps en cas d'extinction de l'une des lampes d'éclairage de sécurité 130, 131,
- un circuit de réception d'ordre de télécommande 38 relié en entrée à l'entrée de télécommande 18 du bloc d'éclairage de sécurité, et en sortie à l'entrée de déclenchement 31 du compteur de temps 30 et
- un circuit d'alimentation 39 branché en 40 sur l'alimentation normale et en 41 sur la batterie d'accumulateurs 11 qui le secourt en cas de coupure du secteur.

La figure 2 détaille un mode de réalisation du bloc d'éclairage de sécurité 1 de la figure précédente. Son circuit d'alimentation 10 connecté au secteur 2 comprend un fusible de protection 100, un transformateur d'isolement et d'adaptation de tension 101 et un pont redresseur 102.

Le circuit de charge 12 de la batterie d'accumulateurs 11 renferme un transistor de type PNP 120 monté en source de courant grâce à des résistance 121, 122, 123, 124 et placé en série avec une diode antiretour 125. Le transistor 120 maintient une tension sensiblement constante aux bornes de sa résistance d'émetteur 121 qui se trouve de ce fait traversée par un courant constant. Ce courant constant sert à la charge de la batterie d'accumulateurs 11 à laquelle il parvient selon un trajet principal empruntant le transistor 120, sa résistance de collecteur 122 et la diode d'isolement 125 et selon un trajet de dérivation empruntant la lampe test 132, les deux lampes de sécurité 130 et 131 et les résistances shunt 133, 134. Le passage du courant de charge dans le trajet de dérivation provoque l'allumage de la lampe de test et assure ainsi un auto-test de la charge de la batterie d'accumulateurs 11 et du bon état des lampes d'éclairage de sécurité 130 et 131.

Le circuit de gestion du bloc 15 comporte un circuit de détection de coupure de l'alimentation normale contrôlant une bascule bistable repositionnable.

Le circuit de détection de coupure de l'alimentation normale est formé d'un transistor 160 de type NPN monté en émetteur commun, polarisé par un pont diviseur de tension à résistances 161, 162 et alimenté aux bornes d'un condensateur 163 chargé par l'intermédiaire d'une diode antiretour 164 et d'une résistance 165 par la tension disponible en sortie du circuit d'alimentation 10 branché sur le secteur 2. En présence du secteur le condensateur 163 se charge suffisamment pour polariser le transistor 160 à saturation et lui imposer une tension collecteur proche de zéro. En cas de coupure du secteur, le condensateur 163 se décharge au travers du circuit collecteur émetteur du transistor 160 jusqu'à ce que ce dernier se bloque ; il apparait alors une pointe de tension au collecteur du transistor 160 qui est utilisée pour faire changer d'état la bascule bistable. La résistance 165 placée devant la diode 164 limite le courant de charge de la capacité 163 et permet en outre la mise à la masse de l'anode de la diode 164 par l'entrée d'inhibition 20 pour simuler une coupure de l'alimentation normale sans, pour autant, court-circuiter la sortie du circuit d'alimentation 10.

La bascule bistable est formée de deux transistors complémentai res 170, 171 montés en émetteur commun aux bornes de la batterie d'accumulateurs 11 contrôlant chacun par leur collecteur un pont résistif 172, 173 ou 174, 175 assurant la polarisation base de l'autre de manière à être simultanément bloqués ou saturés. Le collecteur du transistor 171 de type PNP constitue la sortie 19 du circuit de gestion de bloc qui commande l'excitation du relais fermant l'interrupteur commandé 14.

Le circuit de détection de coupure de l'alimentation normale contrôle la polarisation de la base du transistor 170 de la bascule.

En présence de l'alimentation secteur, le circuit de détection de coupure de l'alimentation normale impose à la base du transistor 170 de la bascule une tension proche de zéro qui a pour effet de bloquer ce transistor 170 et par voie de conséquence l'autre transistor 171 de la bascule. Le transistor 171 étant bloqué, la bobine du relais de l'interrupteur commandé 14 n'est pas alimentée ; ce dernier est ouvert et les lampes de sécurité 130, 131 ne sont pas branchées aux bornes de la batterie d'accumulateurs 11. Le bloc d'éclairage de sécurité est en état de veille, avec ses lampes d'éclairage de sécurité éteintes et sa batterie recevant le courant de charge.

En cas de coupure de l'alimentation secteur, le circuit de détection de coupure de l'alimentation normale engendre sur sa sortie une impulsion de tension positive qui sature le transistor 170 de la bascule ce qui provoque la saturation du transistor 171 et l'excitation de la bobine du relais de l'interrupteur commandé 14 qui se ferme branchant les lampes de sécurité 130, 131 aux bornes de la batterie d'accumulateurs 11 et faisant passer le bloc d'éclairage de sécurité à l'état de fonctionnement, avec ses lampes d'éclairage de sécurité allumées.

Une fois la coupure de l'alimentation secteur établie et l'impulsion de tension positive écoulée la sortie du circuit de détection de coupure de l'alimentation normale présente une impédance suffisante pour ne pas provoquer le reblocage du transistor 170 maintenu à la saturation par l'autre transistor 171. Les deux transistors 170 et 171 de la bascule restent à l'état saturé maintenant le bloc d'éclairage de sécurité dans son état de fonctionnement.

Plus la coupure de l'alimentation secteur se prolonge, plus la batterie d'accumulateurs 11 se décharge et la tension d'alimentation de la bascule décroît entraînant une diminution de la polarisation à saturation des deux transistors 170 et 171 de la bascule. En deçà d'un certain seuil de tension, ces deux transistors 170 et 171 qui ne peuvent plus se maintenir mutuellement saturés, se bloquent entraînant l'arrêt de l'excitation de la bobine du relais de l'interrupteur commandé 14 qui s'ouvre provoquant l'extinction des lampes d'éclairage de sécurité 130, 131 et faisant passer le bloc d'éclairage de sécurité à l'état de repos (lampes de sécurité éteintes en l'absence de la source d'alimentation normale).

L'entrée de télécommande 18 est connectée par une résistance 180 à la base du transistor 170 de la bascule bistable du circuit de gestion de bloc 15. Elle permet, en l'absence d'alimentation secteur de bloquer ou de saturer le transistor 170 en absorbant ou en injectant par la résistance 180 un courant dans la jonction base émetteur de ce transistor et par conséquent de contrôler l'état de la bascule c'est-à-dire l'état de fonctionnement ou de repos du bloc d'éclairage de sécurité.

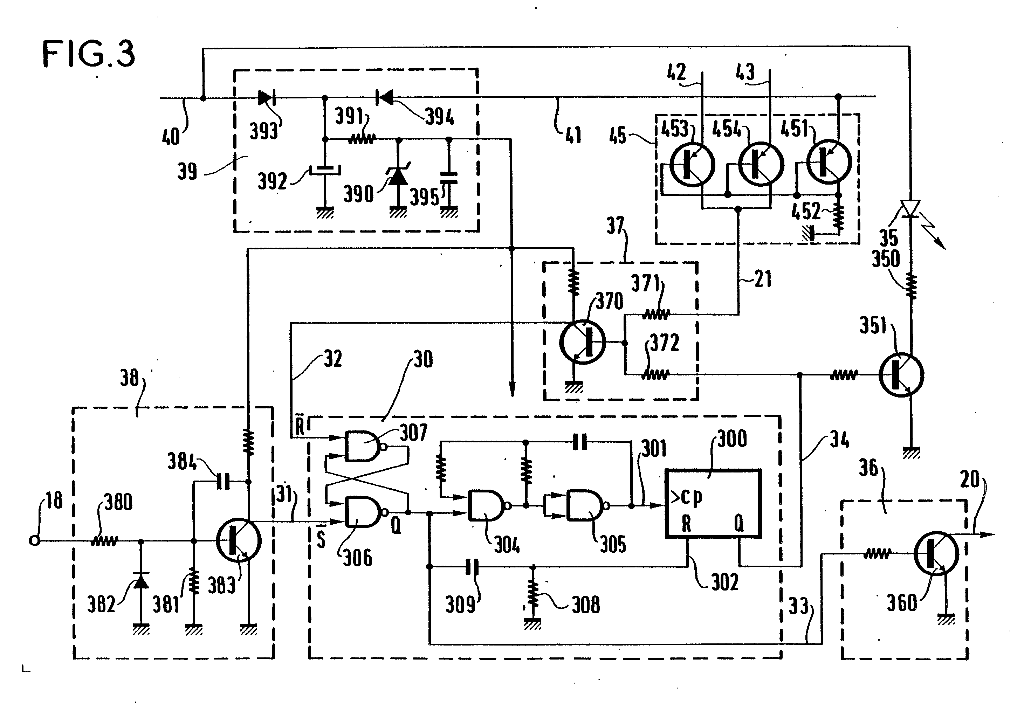

La figure 3 détaille un mode de réalisation du dispositif de test d'autonomie 3 de la figure 1.

Dans ce dispositif de test, le compteur de temps 30 est réalisé à partir d'un compteur numérique 300, d'un oscillateur blocable formé de deux portes logiques de type "et non" 304, 305 placées en régime oscillant par un réseau de résistances et de capacité et d'une bascule bistable de type $\overline{R\ S}$ formée de deux portes logiques de type "et non" 306, 207.

Le compteur numérique 300 présente une entrée de comptage 301, une entrée de remise à zéro 302 sensible à des impulsions positives et une sortie dont le bit de plus fort poids constitue celle de visualisation 34 du compteur de temps 30.

La bascule bistable de type $\overline{R\ S}$ détermine l'état de blocage ou de déblocage du compteur de temps 30. Elle est connectée par sa sortie Q qui constitue la sortie d'état 33 du compteur de temps 30 à la commande de blocage ou de déblocage de l'oscillateur, au circuit de simulation 36 et, par l'intermédiaire d'un générateur d'impulsions à résistance 308 et capacité 309, à l'entrée de remise à zéro du compteur numérique 300. Son entrée $\overline{S}$ constitue l'entrée de déclenchement 31 du compteur de temps 30 tandis que son entrée $\overline{R}$ constitue celle de blocage 32 du compteur de temps 30. Le passage de sa sortie Q du niveau logique 0 au niveau logique 1 débloque l'oscillateur et provoque l'apparition d'une impulsion positive remettant à zéro le compteur numérique 300 tandis que le passage inverse du niveau logique 1 au niveau logique 0 bloque l'oscillateur et engendre une impulsion négative sans effet sur la remise à zéro du compteur numérique 300.

La porte logique de type "non ou" 37 à deux entrées qui transforme le compteur de temps 30 en minuterie tout en permettant son blocage en l'état par l'arrêt du bloc d'éclairage de sécurité est formée, classiquement, par un transistor 370 monté en émetteur commun et attaqué par deux résistances 371, 372 reliant sa base, l'une à la sortie de visualisation 34 du compteur de temps 30 et l'autre à la sortie 21 du circuit 45 de mesure de courant.

Le circuit 45 de mesure de courant comporte une source de tension de référence déterminant le seuil de deux détecteurs à seuil recevant chacun en entrée la tension développée aux bornes d'une résistance shunt 133, 134 par le courant parcourant chaque lampe d'éclairage de sécurité 130, 131.

La source de tension de référence est formée de la jonction base émetteur d'un transistor 451 de type PNP ayant sa base reliée à son collecteur, son émetteur connecté en 41 au pôle positif de la batterie d'accumulateurs 11 en compagnie de l'une des extrémités des résistances shunt 133, 134 et son collecteur relié par l'intermédiaire d'une résistance de polarisation 452 à la masse c'est-à-dire au pôle négatif de la batterie d'accumulateurs 11.

Chaque détecteur à seuil comporte un transistor 453, 454 de type PNP connecté par son émetteur en 42 ou 43 au point de connexion entre une lampe d'éclairage de sécurité 130, 131 et sa résistance shunt 133, 134, par sa base à la base du transitor 451 de la source de tension de référence et par son collecteur à la sortie 21 du circuit 45 de mesure de courant.

Lorsque l'interrupteur commandé 14 est fermé et les lampes d'éclairage de sécurité 130, 131 normalement allumées, les courants traversant ces dernières provoquent de faibles chutes de tension dans les résistances shunt 133, 134 qui bloquent les transistors 453, 454 en rendant la tension de leur jonction émetteur base inférieure à celle de la jonction émetteur base du transistor 451 de la source de tension de référence. Les collecteurs des transistors 453, 454 qui sont réunis pour former la sortie 21 du circuit 45 de mesure de courant sont alors dans un état de haute impédance et ne débitent aucun courant.

Lorsque l'interrupteur commandé 14 ouvert ou lors d'une baisse anormale du courant traversant l'une des lampes d'éclairage de sécurité, l'absence ou la baisse de la chute de tension développée aux bornes des résistances shunt 133, 134 ou de l'une d'entre elles entraîne la mise en conduction de l'un au ·moins des transistors 453, 454 et l'apparition d'un courant au travers de la sortie 21 du circuit 45 de mesure de courant.

Le circuit de simulation 36 est réalisé à l'aide d'un transistor 360 monté en interrupteur entre la masse et l'entrée d'inhibition 20 du circuit de gestion de bloc.

Le circuit de réception d'ordre de télécommande 38 est formé d'un pont résistif diviseur de tension 380, 381, connecté entre la masse et l'entrée de télécommande 18, pourvu d'une diode 382 de protection en inverse et suivi d'un étage à transistor 383 monté en émetteur commun.

Le voyant 35 est une diode électroluminescente alimentée par le secteur et, placée en série avec une résistance de limitation de courant 350 et l'espace collecteur émetteur d'un transistor 351 commandé en interrupteur par la sortie de visualisation 34 du compteur de temps 30 entre la masse et la sortie 40 du circuit d'alimentation du bloc d'éclairage de secours.

Le circuit d'alimentation 39 du dispositif de test comporte un ensemble de régulation de tension formé par une diode Zener 390 connectée en série avec une résistance 391 aux bornes d'un condensateur de filtrage 392 chargé, en cas d'alimentation normale, par le secteur grâce à une diode 393 le reliant à la sortie 40 du circuit d'alimentation du bloc d'éclairage de secours et, en cas d'absence d'alimentation normale, par la batterie d'accumulateurs 11 du bloc d'éclairage de secours grâce à une diode 394 raccordée en 41 sur cette dernière. Le dispositif de test est ainsi constamment alimenté quel que soit l'état de veille, de fonctionnement ou de repos du bloc d'éclairage de sécurité, soit par l'énergie fournie par l'alimentation normale, soit par celle, même résiduelle, de la batterie d'accumulateurs après une autonomie complète.

Le transistor 383 du circuit de réception d'ordre de télécommande de test est bloqué en l'absence de tension sur l'entrée de téléecommande 18 ou en présence sur cette entrée de télécommande 18 d'impulsions de télécommande d'extinction du bloc d'éclairage de sécurité ou de réallumage car les premières sont de polarité négative et les secondes de tension insuffisante par exemple 12 volts pour débloquer la jonction émetteur base du transistor 383 par l'intermédiaire du pont diviseur résistif 380, 381. Par contre, ce transistor 383 se sature lors de l'application sur l'entrée de télécommande d'une impulsion de télécommande de test de même polarité qu'une télécommande de réallumage du bloc mais de tension suffisante par exemple 24 volts pour engendrer en sortie du circuit de réception d'ordre de télécommande de test 38 un niveau logique 0 déclenchant le test d'autonomie.

Ce niveau logique 0 entraîne en effet le passage au niveau logique 1 de la sortie Q de la bascule $\overline{R}\ \overline{S}$ formée par les portes logiques 306, 307 ce qui a pour effet :
- l'envoi d'une impulsion positive par le réseau à résistance et capacité 308, 309 à l'entrée de remise à zéro du compteur numérique 300 dont la sortie, y compris son bit de plus fort poids passe à zéro,
- la mise en conduction du transistor 360 du circuit de simulation 36,
- le déblocage de l'oscillateur formé des portes logiques 304, 305.

Le passage au niveau logique 0 s'il n'y était pas déjà du bit de plus fort poids de la sortie du compteur numérique 300 bloque le transistor 351 et éteint la diode électroluminescente du voyant 35 de test d'autonomie.

La mise en conduction du transistor 360 du circuit de simulation 36 simule pour le circuit de gestion du bloc d'éclairage de sécurité une coupure de l'alimentation normale de sorte que les transistors complémentaires 170, 171 (figure 2) de ce dernier passent s'ils ne l'étaient pas déjà à l'état de conduction et excitent la bobine du relais constituant l'interrupteur commandé 14 (figure 2) qui se ferme et provoque l'allumage des lampes d'éclairage de sécurité 130, 131 à partir de la batterie d'accumulateurs. Le bloc d'éclairage de sécurité passe en état de fonctionnement.

Dans le cas où le bloc était à l'état de repos lors de la réception de l'ordre de test, le passage à l'état de fonctionnement est directement provoqué par la polarisation du transistor 170 par la résistance 180 et la mise en conduction du transistor 360 interdit le retour à l'état de veille en cas de rétablissement de l'alimentation normale en cours de test d'autonomie.

L'allumage des lampes d'éclairage de sécurité 130, 131 consécutif à la fermeture de l'interrupteur commandé 14, provoque l'apparition de tension aux bornes des résistances shunt 133, 134 qui bloquent les transistors 453, 454 et font passer la sortie 21 du circuit 45 de mesure de courant au niveau logique 0. En réponse, la sortie de la porte logique "non ou" 37 (figure 1) bascule au niveau logique 1 et maintient en l'état la bascule de type $\overline{R}\ \overline{S}$ formée par les portes logiques 306, 307, même après retour au niveau logique 1 de la sortie du circuit de réception d'ordre de télécommande 38.

Le déblocage de l'oscillateur formé par les portes logiques 306, 307 entraîne l'émission d'impulsions périodiques comptées par le compteur numérique 300 qui ayant été remis à zéro en début de test comptabilise le temps écoulé.

La fin du test peut être provoquée par le fait que le test s'est déroulé sur la durée prévue ou bien par l'arrivée en fin de décharge de la batterie d'accumulateurs ou encore par un mauvais fonctionnement de l'une des lampes d'éclairage de sécurité.

L'écoulement du temps correspondant à la durée prévue pour le test est attesté par le passage du bit de plus fort poids de la sortie du compteur numérique 300 à l'état logique 1, la fréquence de l'oscillateur et la capacité du compteur numérique ayant été choisies en conséquence tandis que la fin de décharge de la batterie d'accumulateurs ou le mauvais fonctionnement de l'une des lampes d'éclairage de sécurité sont attestés par le passage au niveau logique 1 de la sortie 21 du circuit 45 de mesure de courant ce passage étant dû à l'ouverture de l'interrupteur commandé 14 par suite du blocage des transistors complémentaires 170, 171 en raison d'une polarisation insuffisante par la batterie d'accumulateurs ou au mauvais fonctionnement de l'une des lampes d'éclairage de sécurité.

Ces évènements provoquent l'application d'un niveau logique 0 par la porte logique de type "non ou" 37 sur l'entrée $\overline{R}$ de la bascule $\overline{R}\ \overline{S}$ du compteur de temps 30. Comme l'entrée $\overline{S}$ de la bascule de type $\overline{R}\ \overline{S}$ est repassée au niveau logique 1 après la fin de réception d'un ordre de télécommande de test, sa sortie passe au niveau logique 0 bloquant à la fois le circuit de simulation 36 et l'oscillateur formé des portes logiques 304 et 305.

Le blocage du circuit de simulation 36 permet au condensateur 163 (figure 2) du circuit de gestion de bloc de se recharger et de débloquer le transistor 160 qui commande le blocage, s'il ne l'était pas déjà, des transistors complémentaires 170 et 171, l'arrêt d'excitation du relais de l'interrupteur commandé 14 et donc l'extinction des lampes d'éclairage de sécurité. Le bloc d'éclairage de sécurité revient à l'état de veille et la batterie repart en charge.

Le blocage de l'oscillateur formé des portes logiques 304 et 305 laisse le compteur numérique 300 en l'état. Deux cas sont possible :
- la fin du test a été provoquée par le circuit de mesure de courant. Le digit de plus fort poids de la sortie du compteur numérique 300 est resté au niveau logique 0 montrant que l'autonomie réelle du bloc d'éclairage de sécurité n'atteint pas l'autonomie nominale. La diode électroluminescente du voyant 35 n'est pas alimentée et reste éteinte témoignant d'un test négatif,
- la fin du test a été provoquée par le passage au niveau logique 1 du digit de plus fort poids de la sortie du compteur numérique 300 montrant que le test s'est prolongé sur la durée voulue sans atteindre la fin de décharge de la batterie d'accumulateurs. Le transistor 351 est alors saturé et la diode électroluminescente du voyant 35 allumée en présence d'alimentation normale témoignant d'un test positif.

L'état de la diode électroluminescente du voyant 35 reste inchangé entre deux tests d'autonomie.

Les tests d'autonomie s'effectuent normalement en présence de l'alimentation normale et il faut tenir compte, pour déterminer la durée maximale du test, du fait que la batterie d'accumulateurs du bloc continue à être chargée alors qu'elle ne l'est pas lorsque le bloc d'éclairage de secours est en marche normale. Cette durée maximale de test doit alors être supérieure à la durée d'autonomie nominale du bloc de l'ordre de 10 à 30% pour les batterie d'accumulateurs recevant un courant de charge correspondant à une charge en 24 heures et se déchargeant en 1 à 3 heures dans les lampes de sécurité.

Le test d'autonomie n'est valable que si l'alimentation normale a été présente suffisamment longtemps entre la dernière autonomie et le début du test et si le test n'a pas été annulé avant son terme par une télécommande d'extinction.

Il reste valable, en cas de coupure effective de l'alimentation normale aux erreurs près dues à l'annulation du courant de charge batterie qui en résulte, sauf dans le cas où cette charge batterie est bloquée durant le test.

Si l'arrêt d'un test en cours, par une télécommande d'extinction, est interdit, il est nécessaire de bloquer les impulsions de télécommande durant le test par exemple à l'aide d'un transistor monté en interrupteur commandé placé en série avec la résistance 180 et commandé en sens inverse du circuit de simulation 36.

On peut, sans sortir du cadre de l'invention modifier certaines dispositions ou remplacer certains moyens par des moyens équivalents.

## Revendications

1/ Appareil de test d'autonomie pour bloc d'éclairage de sécurité (1) comportant au moins une lampe de sécurité (130), une batterie d'accumulateurs (11) destinée à alimenter la lampe de sécurité (130), un circuit (12) de charge de la batterie d'accumulateurs (11) connecté à une alimentation dite normale (2) dont la coupure doit entraîner l'allumage du bloc d'éclairage de sécurité (1), un interrupteur commandé (14) connectant la lampe de sécurité (130) aux bornes de la batterie d'accumulateurs (11) et un dispositif de gestion de bloc (15) contrôlant l'interrupteur commandé (14) et le fermant lorsque l'alimentation normale (2) disparaît et que la batterie d'accumulateurs (11) délivre une tension supérieure à un seuil minimum, ledit appareil de test (3) étant caractérisé en ce qu'il comporte un compteur de temps déclenchable (30), un circuit de simulation (36) qui est contrôlé par le compteur de temps (30) et qui, pendant le fonctionnement de ce dernier simule, pour le circuit de gestion de bloc (15), une coupure de l'alimentation normale (2), un circuit de visualisation de la durée de fonctionnement du compteur de temps (30) et un circuit (45) de mesure du courant traversant chaque lampe d'éclairage de sécurité (130, 131) qui bloque le compteur de temps (30) lorsque ledit courant est inférieur à une valeur de seuil.

2/ Appareil de test d'autonomie selon la revendication 1, caractérisé en ce qu'il comporte une résistance shunt (133, 134) par lampe d'éclairage de sécurité (130, 131) intercalée en série avec chaque lampe d'éclairage de sécurité et en ce que le circuit (45) de mesure de courant comporte un détecteur à seuil (453, 454) par lampe d'éclairage de sécurité recevant en entrée la tension développée aux bornes d'une résistance shunt (133, 134) et une source de tension de référence (451 déterminant le seuil de chaque détecteur à seuil (453, 454).

3/ Appareil de test d'autonomie selon la revendication 2, caractérisé en ce que la source de tension de référence comporte un transistor à jonctions base émetteur collecteur ayant sa base connectée à son collecteur, son émetteur connecté à l'un des pôles de la batterie d'accumulateurs (11) en compagnie de chaque résistance shunt (133, 134) et son collecteur relié par l'intermédiaire d'une résistance de polarisation (452) à l'autre pôle de la batterie d'accumulateurs (11).

4/ Appareil de test d'autonomie selon la revendication 3, caractérisé en ce que chaque détecteur à seuil comporte un transistor à jonctions base émetteur collecteur ayant son émetteur connecté au point de connexion entre une lampe d'éclairage de sécurité (130, 131) et sa résistance shunt (133, 134), sa base reliée à celle du transistor (451) de la source de tension de référence et son collecteur relié à la sortie (21) du circuit (45) de mesure du courant.

FIG.1

FIG.2

EP 0 342 579 A1

FIG.3

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4 ) |
|---|---|---|---|
| Y,D | EP-A-0171629 (SAFT SA) <br> * page 4, ligne 13 - page 14, ligne 35; figures 1-7 * | 1 | H02J9/00 <br> G01R31/36 |
| Y | DE-C-3213003 (THEO BENNING ELEKTROTECHNIK UND ELEKTRONIK GMBH) <br> * colonne 4, ligne 38 - colonne 7, ligne 22; figure 1 * | 1 | |
| A | | 2 | |
| A | EP-A-0030154 (EMLUX LTD) <br> * page 3, ligne 19 - page 7, ligne 35; figures 1-3 * | 1 | |
| A | EP-A-0225106 (BRITISH AEROSPACE LTD) <br> * colonne 4, ligne 36 - colonne 5, ligne 41; figures 2, 7, 8 * | 1 | |
| A | EP-A-0206488 (SALPLEX LTD) <br> * page 3, ligne 3 - page 4, ligne 25; figure 1 * | 1, 2 | |

DOMAINES TECHNIQUES
RECHERCHES (Int. Cl.4 )

H02J
G01R

Le présent rapport a été établi pour toutes les revendications

| Lieu de la recherche | Date d'achèvement de la recherche | Examinateur |
|---|---|---|
| LA HAYE | 01 AOUT 1989 | FOURRICHON P.M.L. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
.........................................................................
& : membre de la même famille, document correspondant

EPO FORM 1503 03.82 (P0402)